# EUROPÄISCHE PATENTSCHRIFT

(11) **EP 1 909 339 B1**
(45) Veröffentlichungstag und Bekanntmachung des Hinweises auf die Patenterteilung: **13.01.2010**
(21) Anmeldenummer: 07116545.0
(22) Anmeldetag: 17.09.2007
(51) Int. Cl.: H01L 41/053, F02M 51/06

(54) **Aktormodul mit einem umhüllten Piezoaktor**
Actuator module having an enshrouded piezo actuator
Module d'actionneur ayant un piezoactionneur gainé

(30) Priorität: 02.10.2006 DE 102006046829
(43) Veröffentlichungstag der Anmeldung: 09.04.2008
(73) Patentinhaber: ROBERT BOSCH GMBH, 70442 Stuttgart (DE)
(72) Erfinder: Heinz, Rudolf, 71272 Renningen (DE); Kienzler, Dieter, 71229 Leonberg (DE); Schaich, Udo, 70378 Stuttgart (DE)

(56) Entgegenhaltungen:
- EP-A- 1 783 842
- WO-A-02/061856
- WO-A-2006/128749
- DE-A1- 19 753 930

## Beschreibung

### Stand der Technik

Die Erfindung betrifft ein Aktormodul mit einem eine Umhüllung aufweisenden Piezoaktor, der beispielsweise in einem Piezoinjektor zur Dosierung von Kraftstoff in einem Verbrennungsmotor angewendet werden kann.

Zur zeitpunkt- und mengengenauen Dosierung von Kraftstoff in Verbrennungsmotoren ist es an sich bekannt, diese sogenannten Piezoinjektoren zu verwenden.

Ein Piezoinjektor besteht im Wesentlichen aus einem Haltekörper und dem im Haltekörper angeordneten Piezoaktor, der zwischen einem Aktorkopf und einem Aktorfuß angeordnete, übereinandergestapelte Piezoelemente aufweist, die jeweils aus mit Innenelektroden eingefassten Piezolagen bestehen. Die Piezoelemente sind unter Verwendung eines Materials mit einer geeigneten Kristallstruktur (Piezokeramik) für die Piezolagen so aufgebaut, dass bei Anlage einer äußeren Spannung an die Innenelektroden eine mechanische Reaktion der Piezoelemente erfolgt, die in Abhängigkeit von der Kristallstruktur und der Anlagebereiche der elektrischen Spannung einen Druck oder Zug in eine vorgebbare Richtung darstellt. Der Piezoaktor ist bei einem Piezoinjektor mit einer Düsennadel derart verbunden, dass so durch Anlegen einer Spannung an die Piezoelemente eine Düsenöffnung freigegeben wird.

In Diesel-Piezoinjektoren werden bei der so genannten direkten Düsennadelsteuerung die Piezoaktoren direkt im Dieselkraftstoff unter Hochdruck betrieben. Zum Schutz der Piezoelemente, beispielsweise im Hinblick auf deren elektrische Isolation, ist es bekannt, den Piezoaktor mit einem dieselfesten Elastomer zu umhüllen. Nachteilig hieran ist, dass hierfür verwendete weiche Elastomere nicht diffusionsfest gegenüber Dieselkraftstoff, Wasser sowie sonstigen Medien im Kraftstoff sind.

Um eine elektrische und mechanische Isolierung des Piezoaktors zu erreichen, wird oft eine zusätzliche Hülse vorgeschlagen. Aus der DE 102 300 32 A1 ist zur Vermeidung der zuvor beschriebenen Nachteile eine Anordnung mit einem Piezoaktor in umströmenden Medien bekannt, bei der die Piezoelemente in einer formveränderlichen Isolationsmasse vergossen sind, die wiederum in einer seitlich und am oberen und unteren Ende gegenüber dem Medium verschlossenen Hülse eingebracht ist.

Diese bekannten Umhüllungen des Piezoaktors bilden, insbesondere dann wenn die äußere Hülse aus einem flexiblen Material gebildet werden soll, an den Anlagebereichen des Aktorkopfs und des Aktorfußes, die vorwiegend aus Stahl hergestellt sind, kritische Dichtbereiche. Es besteht bei einer Anwendung in einem Piezoinjektor, bei dem das Aktormodul vom Kraftstoff, zum Beispiel Diesel, unter hohem Druck umströmt wird, insbesondere die Gefahr, dass die Anlagebereiche der Hülse am Aktorkopf und am Aktorfuß des Piezoaktors vom Kraftstoff unterwandert werden und somit die Funktionsfähigkeit des Aktormoduls über seine Lebensdauer nicht gewährleistet ist. Die bekannten Umhüllungen aus Stahl sind nicht hochdruckfest bei 2000 bar Flüssigkeitsdruck.

Aus der nicht vorveröffentlichten WO 2006/128749 A1 ist bereits ein Aktormodul mit einem Piezoaktor bekannt, der zwischen einem Aktorkopf und einem Aktorfuß angeordnete Piezoelemente aufweist und von einer Umhüllung umgeben ist, die aus einer mindestens die Piezoelemente umgebenden Elastomerschicht und einer äußeren flüssigkeitsdichten, den Piezoaktor und die Elastomerschicht umschließenden Hülse besteht. Die Hülse ist dabei aus einem unter Temperatureinwirkung schrumpfbaren Schrumpfschlauch gebildet, der in Anlagebereichen auf dem Aktorkopf und dem Aktorfuß des Piezoaktors dichtend anliegt. In den Bereichen des Aktorkopfes sowie des Aktorfußes ist jeweils ein Pressring vorgesehen, die außen auf dem Schrumpfschlauch angeordnet sind und den Schrumpfschlauch auf die Anlagebereiche drücken. Die Pressringe sind dabei mit einer nach innen gerichteten umlaufenden Wulst versehen, die in eine entsprechend am Aktorkopf bzw. am Aktorfuß vertieft ausgebildete Nut eingreift und den Schrumpfschlauch auf diese Weise am Aktorkopf bzw. am Aktorfuß in der Nut festhält. Eine alternative Ausführung sieht anstelle der Pressringe eine Befestigungshülse vor, die eine der Wulst vergleichbare nach innen gerichtete umlaufende Sicke aufweist, um den Schrumpfschlauch in die Nut zu drücken und damit für eine zuverlässige Verbindung des Schrumpfschlauchs mit dem Aktorkopf zu sorgen. Bei diesen Ausführungen sind die Pressringe bzw. 8efestigungshülsen stets so ausgeformt und angebracht, dass die sichere Befestigung des Schrumpfschlauchs am Aktorkopf bzw. am Aktorfuß garantiert ist, wobei eine ausschließlich statische Einwirkung der Befestigungskörper vorliegt und gewünscht ist.

### Offenbarung der Erfindung

Die Erfindung geht von einem eingangs beschriebenen Aktormodul mit einem Piezoaktor aus, der zwischen einem Aktorkopf und einem Aktorfuß angeordnete Piezoelemente aufweist. Es ist eine Umhüllung vorhanden, die aus einer mindestens die Piezoelemente umgebenden Elastomerschicht und einer äußeren flüssigkeitsdichten, den Piezoaktor und die Elastomerschicht umschließenden Hülse besteht. Erfindungsgemäß ist die Hülse aus einem unter Temperatureinwirkung schrumpfenden Schrumpfschlauch gebildet, der in vorteilhafter Weise in Anlagebereichen auf dem Aktorfkopf und dem Aktorfuß des Piezoaktors dichtend anliegt und es ist mindestens ein Pressring außen auf dem Schrumpfschlauch angeordnet, der den Schrumpfschlauch auf die Anlagebereiche drückt.

Der jeweilige Pressring ist gemäß der Erfindung vorzugsweise aus Metall oder einem Memory-Metall (NiFe-Legierung) hergestellt und derart mit einer äußeren und/oder inneren Oberflächenkontur ausgestattet, dass auch bei einer Volumen- oder Lageänderung des Schrumpfschlauchs die Anpresskraft des jeweiligen Pressringes erhalten bleibt. Ein Memory-Metall ist dann besonders vorteilhaft, wenn ein großes Schrumpfmaß erreicht werden soll, ohne ein zusätzliches Verpressen des Pressringes.

Erfindungsgemäß weist der jeweilige Pressring auf seiner äußeren und/oder inneren Oberflächenkontur radial umlaufende Wellen oder Sicken oder mindestens eine nach außen ragende Bördelung auf, die ein Nachfedern des Pressringes auch bei einer Volumen- oder Lageänderung des Schrumpfschlauchs dadurch ermöglichen, dass eine verstärkte radiale Elastizität in die Pressringe eingebracht wird, wobei die Anpresskraft des jeweiligen Pressringes erhalten beleibt. Eine Volumen- oder Lageänderung des Schrumpfschlauchs kann dabei beispielsweise durch ein Nachfließen des Schrumpfschlauches im Betrieb erfolgen.

Bei weiteren vorteilhaften Ausführungsformen kann der jeweilige Pressring auf seiner inneren Oberflächenkontur radial umlaufende ringförmige Erhöhungen aufweisen, die eine Kammerung des mit dem Pressring eingepressten Schrumpfschlauches bewirken und somit auch eine Fließbehinderung des Schrumpfschlauches darstellen.

Die vorgeschlagenen Oberflächenkonturen können auch aus radial umlaufenden Erhöhungen oder Vertiefungen am Umfang des Anlagebereichs des Schrumpfschlauches am Aktorkopf und/oder am Aktorfuß bestehen, die beispielsweise einen rechteckigen oder kegelförmigen Querschnitt aufweisen können.

Bei einem weiteren nicht erfindungsgemäßen Beispiel presst der Pressring in seiner axialen Erstreckung an seiner inneren, den Piezoelementen zugewandten Seite den Schrumpfschlauch ein und bildet daher einen Radialanschlag zum Schutz gegen ein Abquetschen des Schrumpfschlauchs. An der anderen äußeren Seite liegt er derart auf dem Aktorkopf und/oder dem Aktorfuß auf, dass dazwischen ein Ausgleichraum für den Schrumpfschlauch vorhanden ist, wobei von dem Ausgleichsraum nach außen mindestens eine Längsnute zum Druckausgleich geführt sein kann.

Bei einer bevorzugten Anwendung der Erfindung ist das Aktormodul mit dem Piezoaktor Bestandteil eines Piezoinjektors für ein Einspritzsystem für Kraftstoff bei einem Verbrennungsmotor, wobei der Kraftstoff den Schrumpfschlauch umströmt.

### Kurze Beschreibung der Zeichnungen

Die Erfindung wird nachfolgend anhand der Zeichnungen erläutert. Dabei zeigen:
Figur 1 eine schematische Darstellung eines Piezoinjektors mit einem Aktormodul nach dem Stand der Technik im Längsschnitt,
Figur 2 eine schematische Darstellung eines erfindungsgemäßen Aktormoduls mit Pressringen über einem am Aktorkopf und am Aktorfuß des Piezoaktors anliegenden Schrumpfschlauch als Hülse,
Figur 3 eine detaillierte Abbildung des Kopfteils des Piezoaktors nach der Figur 2 mit einem Pressring,
Figur 4 eine Darstellung eines Schnittes A-A durch das Aktormodul nach der Figur 3 mit einer gewellten Oberflächenkontur,
Figur 5 eine Darstellung eines Schnittes A-A durch das Aktormodul nach der Figur 3 mit einem insgesamt gewellten Pressring,
Figur 6 eine Darstellung eines Schnittes A-A durch das Aktormodul nach der Figur 3 mit einer Oberflächenkontur mit Sicken,
Figur 7 eine Darstellung eines Schnittes A-A durch das Aktormodul nach der Figur 3 mit einer Oberflächenkontur mit Bördelungen,
Figur 8 und Figur 9 jeweils eine detaillierte Abbildung des Aktorkopfs nach der Figur 2 mit einem Pressring, der über ringförmig umlaufende Erhöhungen in den Schrumpfschlauch eingreift,
Figur 10 bis Figur 12 jeweils eine detaillierte Abbildung des Aktorkopfs nach der Figur 2 mit ringförmigen Vertiefungen oder Erhöhungen am Aktorkopf und am Aktorfuß des Piezoaktors, in die der Schrumpfschlauch eingreift und
Figur 13 einen Pressring, der einen Ausgleichraum für den Schrumpfschlauch bildet.

### Ausführungsformen der Erfindung

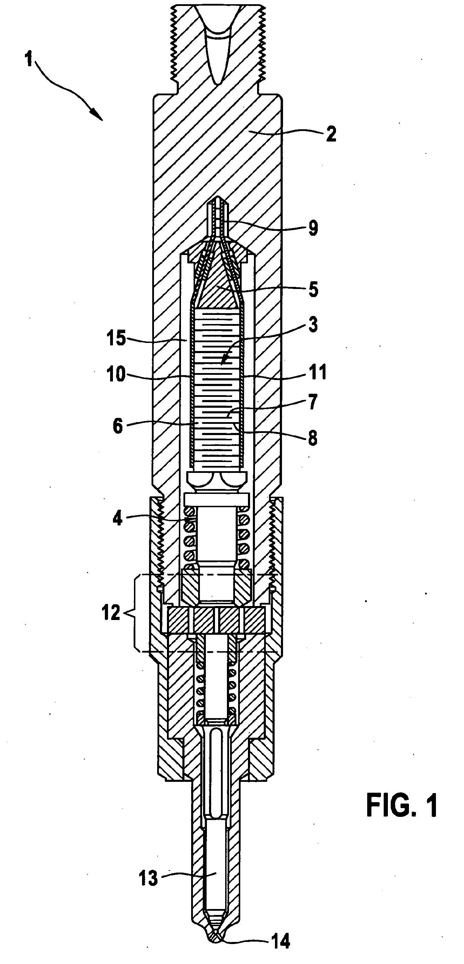

Ein in Figur 1 zur Erläuterung des erfindungsgemäßen Aktormoduls dargestellter Piezoinjektor 1 nach dem Stand der Technik umfasst im Wesentlichen einen Haltekörper 2 und einen in dem Haltekörper 2 angeordneten Piezoaktor 3, der einen Aktorkopf 4 und einen Aktorfuß 5 aufweist. Es sind dabei zwischen dem Aktorkopf 4 und dem Aktorfuß 5 mehrere übereinandergestapelte Piezoelemente 6 vorhanden, die jeweils aus Piezolagen aus Piezokeramik und diese einschließende Innenelektroden 7 und 8 bestehen.

Die Innenelektroden 7 und 8 der Piezoelemente 6 sind über ein Steckerteil 9 mit Zuleitungen zu Außenelektroden 10 und 11 elektrisch kontaktiert. Der Piezoaktor 3, der mit weiteren, hier nicht näher gezeigten Bauteilen ein sogenanntes Aktormodul darstellt, ist über einen Koppler 12 mit einer Düsennadel 13 verbunden. Durch Anlegen einer Spannung an die Piezoelemente 6 über die Innenelektroden 7 und 8 und die daraus folgende mechanische Reaktion wird, wie in der Beschreibungseinleitung erläutert, eine Düsenöffnung 14 freigegeben. Das Aktormodul mit dem Piezoaktor 3 wird bei der dargestellten Anwendung nach der Figur 1 als Piezoinjektor in einem Raum 15 von dem zu dosierenden Kraftstoff umströmt.

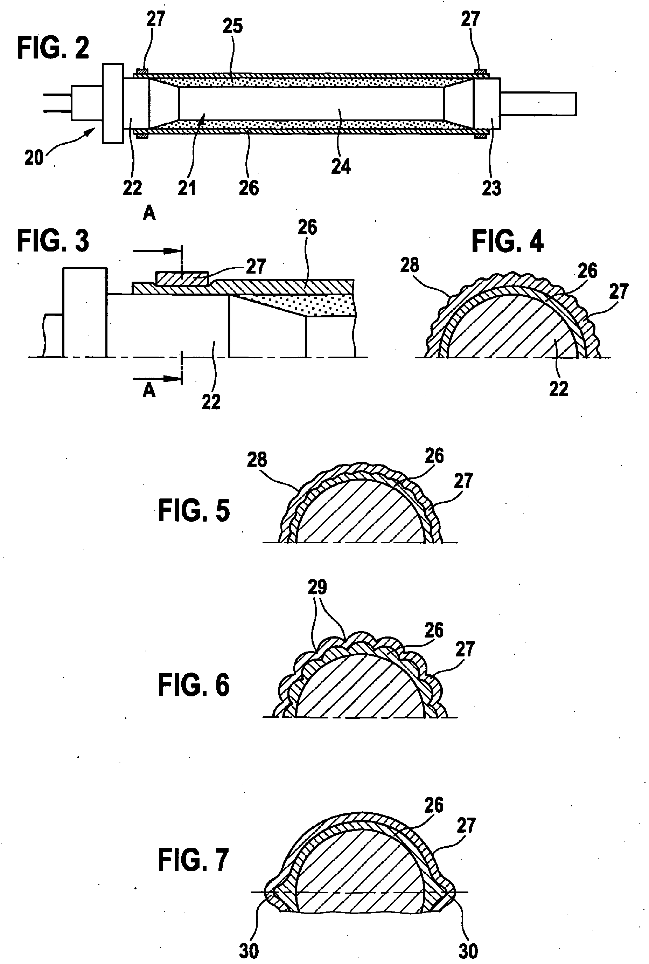

In Figur 2 ist ein erfindungsgemäßes Aktormodul 20 mit einem Piezoaktor 21 als Ausführungsbeispiel dargestellt, der hier vom Aktorkopf 22 zum Aktorfuß 23 einschließlich der hier nicht näher erläuterten Piezoelemente 24 mit einer elektrisch isolierenden Elastomerschicht 25 umgeben ist. Um die Elastomerschicht 25 herum befindet sich eine flüssigkeitsdichte Hülse aus einem unter Temperatureinwirkung schrumpfbaren Schrumpfschlauch 26, der in Anlagebereichen auf dem Aktorkopf 22 und dem Aktorfuß 23 des Piezoaktors 21 durch die Schrumpfung dichtend anliegt. Außen ist hier sowohl im Anlagebereich am Aktorkopf 22 als auch am Aktorfuß 23 des Piezoaktors 21 ein Pressring 27 außen auf dem Schrumpfschlauch 26 angeordnet.

Aus Figur 3 ist ein Ausführungsbeispiel der Erfindung zu entnehmen, bei dem hier der Anlagebereich am Aktorkopf 22 vergrößert dargestellt ist und bei dem nach einer Schrumpfung des Schrumpfschlauchs 26 der Pressring 27 aufgebracht wird. Anhand einer Schnittlinie A-A sollen im Folgenden die Oberflächenkonturen des Pressringes 27 erläutert werden.

Aus Figur 4 ist zu entnehmen, dass auf einer äußeren Oberflächenkontur 28 des Pressrings 27 radial umlaufende Wellen angeordnet sind, die ein Nachfedern des Pressringes 27 auch bei einer Volumen- oder Lageänderung des Schrumpfschlauchs 26 dadurch ermöglichen, dass eine verstärkte radiale Elastizität in die Pressringe 27 eingebracht ist.

Figur 5 zeigt eine insgesamt wellenförmige Oberflächenkontur 28 des Pressrings 27, Figur 6 zeigt Sicken auf einer Oberflächenkontur 29 und Figur 7 zeigt eine Oberflächenkontur 30 mit zwei nach außen ragenden Bördelungen, die alle ebenfalls ein Nachfedern des Pressringes 27 auch bei einer Volumen- oder Lageänderung des Schrumpfschlauchs 26 dadurch ermöglichen, dass eine verstärkte radiale Elastizität in die Pressringe 27 eingebracht ist.

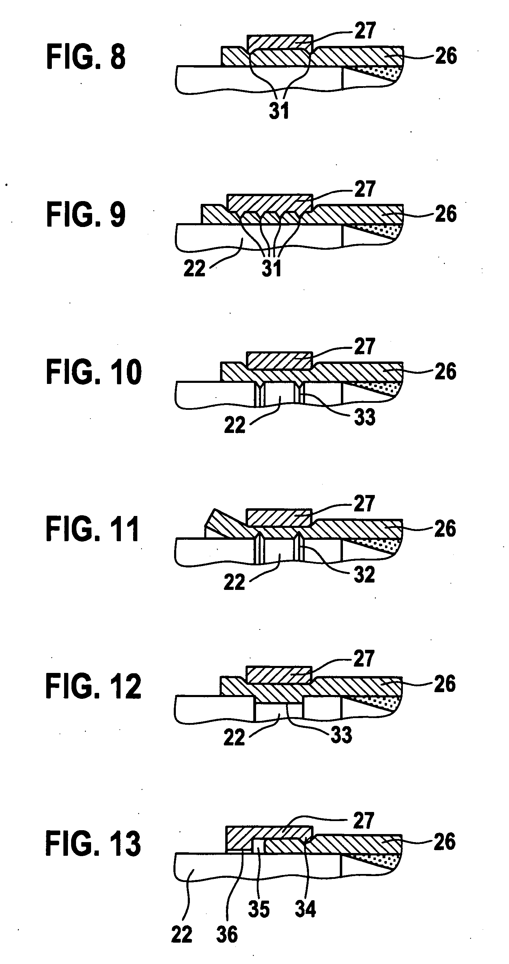

Bei Ausführungsbeispielen nach Figur 8 und 9 ist der jeweilige Pressring 27 auf seiner inneren Oberflächenkontur mit radial umlaufenden ringförmigen Erhöhungen 31 versehen, die eine Kammerung des mit dem Pressring 27 eingepressten Schrumpfschlauches 27 ermöglicht.

Aus Figur 10 bis 13 ist zu entnehmen, dass die vorgeschlagenen ringförmigen Oberflächenkonturen auch aus radial umlaufenden Erhöhungen 32 (Figur 11) oder Vertiefungen 33 (Figur 10 und Figur 12) am Umfang des Anlagebereichs des Schrumpfschlauches 26 am Aktorkopf 22 und/oder am Aktorfuß bestehen können, die entweder einen rechteckigen oder kegelförmigen Querschnitt aufweisen.

Bei einem nicht erfindungsgemäßen Beispiel nach Figur 13 presst der Pressring 27 in seiner axialen Erstreckung an seiner inneren, den Piezoelementen zugewandten Seite 34 den Schrumpfschlauch 26 ein und bildet daher einen Radialanschlag zum Schutz gegen ein Abquetschen des Schrumpfschlauchs 26. An der anderen äußeren Seite liegt er derart auf dem Aktorkopf 22 und/oder am Aktorfuß des Piezoaktors auf, dass dazwischen ein Ausgleichraum 35 für den Schrumpfschlauch vorhanden ist, wobei von dem Ausgleichsraum 35 nach außen noch mindestens eine Längsnute 36 zum Druckausgleich bei einer Ausdehnung geführt sein kann.

Die verstärkte radiale Elastizität der Pressringe 27 nach den Figuren 5, 6 und 7 kann dabei noch verstärkt werden mit der Kammerung anhand der Ausführungsbeispiele nach den Figuren 8 bis 12.

## Patentansprüche

1. Aktormodul mit einem Piezoaktor (3), der zwischen einem Aktorkopf (4) und einem Aktorfuß (5) angeordnete Piezoelemente (6) aufweist und mit einer Umhüllung, die aus einer mindestens die Piezoelemente (6) umgebenden Elastomerschicht und einer äußeren flüssigkeitsdichten, den Piezoaktor (3) und die Elastomerschicht umschließenden Hülse besteht, wobei die Hülse aus einem unter Temperatureinwirkung schrumpfbaren Schrumpfschlauch (26) gebildet ist, der in Anlagebereichen auf dem Aktorkopf (22) und/oder dem Aktorfuß (23) des Piezoaktors (21) dichtend anliegt, und wobei mindestens ein Pressring (27) außen auf dem Schrumpfschlauch (26) angeordnet ist, der den Schrumpfschlauch (26) auf die Anlagebereiche drückt, wobei der jeweilige Pressring (27) auf seiner äußeren und/oder inneren Oberflächenkontur (28,29) radial umlaufende Wellen oder Sicken aufweist, die ein Nachfedern des Pressringes (27) auch bei einer Volumen- oder Lageänderung des Schrumpfschlauchs (26) ermöglichen, wobei die Anpresskraft des jeweiligen Pressringes (27) erhalten bleibt.

2. Aktormodul mit einem Piezoaktor (3), der zwischen einem Aktorkopf (4) und einem Aktorfuß (5) angeordnete Piezoelemente (6) aufweist und mit einer Umhüllung, die aus einer mindestens die Piezoelemente (6) umgebenden Elastomerschicht und einer äußeren flüssigkeitsdichten, den Piezoaktor (3) und die Elastomerschicht umschließenden Hülse besteht, wobei die Hülse aus einem unter Temperatureinwirkung schrumpfbaren Schrumpfschlauch (26) gebildet ist, der in Anlagebereichen auf dem Aktorkopf (22) und/oder dem Aktorfuß (23) des Piezoaktors (21) dichtend anliegt, und wobei mindestens ein Pressring (27) außen auf dem Schrumpfschlauch (26) angeordnet ist, der den Schrumpfschlauch (26) auf die Anlagebereiche drückt, wobei der jeweilige Pressring (27) auf seiner äußeren und/oder inneren Oberflächenkontur (30) mindestens eine nach außen ragende Bördelung aufweist, die ein Nachfedern des Pressringes (27) auch bei einer Volumen- oder Lageänderung des Schrumpfschlauchs (26) ermöglichen, wobei die Anpresskraft des jeweiligen Pressringes (27) erhalten bleibt.

3. Aktormodul nach einem der vorhergehenden Ansprüche, **dadurch gekennzeichnet, dass** der jeweilige Pressring (27) auf seiner inneren Oberflächenkontur radial umlaufende Erhöhungen (31) aufweist, die eine Kammerung des mit dem Pressring (27) eingepressten Schrumpfschlauches (26) bewirken.

4. Aktormodul nach einem der vorhergehenden Ansprüche, **dadurch gekennzeichnet, dass** mindestens eine radial umlaufende Erhöhung (32) oder Vertiefung (33) am Umfang des Anlagebereichs des Schrumpfschlauches (26) am Aktorkopf (22) und/oder am Aktorfuß angeordnet ist, die einen rechteckigen oder kegelförmigen Querschnitt aufweist.

5. Aktormodul nach einem der vorhergehenden Ansprüche, **dadurch gekennzeichnet, dass** der Piezoaktor (21) Bestandteil eines Piezoinjektors für ein Einspritzsystem für Kraftstoff bei einem Verbrennungsmotor ist, wobei der Kraftstoff den Schrumpfschlauch (26) umströmt.

## Claims

1. Actuator module having a piezoactuator (3) which has piezo elements (6) arranged between an actuator head (4) and an actuator foot (5), and with a shroud which consists of an elastomeric layer surrounding at least the piezo elements (6) and of an outer liquid-tight sleeve surrounding the piezoactuator (3) and the elastomeric layer, the sleeve being formed from a shrink-fit tube (26) shrinkable under the action of temperature which bears sealingly in bearing regions on the actuator head (22) and/or on the actuator foot (23) of the piezoactuator (21), and at least one press ring (27) being arranged on the shrink-fit tube (26) on the outside, which press ring presses the shrink-fit tube (26) onto the bearing regions, the respective press ring (27) having, on its outer and/or inner surface contour (28; 29), radially continuous corrugations or beads which allow a resilience of the press ring (27) even in the case of a change in volume or in position of the shrink-fit tube (26), the pressure force of the respective press ring (27) being maintained.

2. Actuator module having a piezoactuator (3) which has piezo elements (6) arranged between an actuator head (4) and an actuator foot (5), and with a shroud which consists of an elastomeric layer surrounding at least the piezo elements (6) and of an outer liquid-tight sleeve surrounding the piezoactuator (3) and the elastomeric layer, the sleeve being formed from a shrink-fit tube (26) shrinkable under the action of temperature, which bears sealingly in bearing regions on the actuator head (22) and/or on the actuator foot (23) of the piezoactuator (21), and at least one press ring (27) being arranged on the shrink-fit tube (26) on the outside, which press ring presses the shrink-fit tube (26) onto the bearing regions, the respective press ring (27) having, on its outer and/or inner surface contour (30), at least one outwardly projecting crimping which allows a resilience of the press ring (27) even in the case of a change in volume or in position of the shrink-fit tube (26), the pressure force of the respective press ring (27) being maintained.

3. Actuator module according to one of the preceding claims, **characterized in that** the respective press ring (27) has, on its inner surface contour, radially continuous elevations (31) which cause a chambering of the shrink-fit tube (26) pressed in by means of the press ring (27).

4. Actuator module according to one of the preceding claims, **characterized in that** at least one radially continuous elevation (32) or depression (33) is arranged on the circumference of the bearing region of the shrink-fit tube (26) on the actuator head (22) and/or on the actuator foot, which elevation or depression has a rectangular or conical cross section.

5. Actuator module according to one of the preceding claims, **characterized in that** the piezoactuator (21) is an integral part of a piezo injector for an injection system for fuel in an internal combustion engine, the fuel flowing around the shrink-fit tube (26).

## Revendications

1. Module d'actionneur doté d'un piézoactionneur (3) qui présente :
des piézoéléments (6) disposés entre une tête d'actionneur (4) et un pied d'actionneur (5),
une enveloppe constituée d'une couche d'élastomère qui entoure au moins les piézoéléments (6) et
une douille extérieure, étanche aux liquides, qui entoure le piézoactionneur (3) et la couche d'élastomère,
la douille étant formée d'un manchon flexible (26) qui rétrécit sous l'action de la température et qui repose de manière étanche dans des zones d'appui sur la tête d'actionneur (22) et/ou le pied d'actionneur (23) du piézoactionneur (21),
au moins une bague de compression (27) étant disposée par l'extérieur sur le tuyau flexible rétrécissable (26) et repoussant le tuyau flexible rétrécissable (26) sur les zones d'appui,
chaque bague de compression (27) présentant sur la surface de son contour extérieur et/ou de son contour intérieur (28; 29) des ondulations ou des moulures périphériques radiales qui donnent une hystérésis élastique à la bague de compression (27) même en cas de modification de volume ou de position du tuyau flexible rétrécissable (26), la force de compression de chaque anneau de compression (27) étant maintenue.

2. Module d'actionneur doté d'un piézoactionneur (3) qui présente :
des piézoéléments (6) disposés entre une tête d'actionneur (4) et un pied d'actionneur (5),
une enveloppe constituée d'une couche d'élastomère qui entoure au moins les piézoéléments (6) et
une douille extérieure, étanche aux liquides, qui entoure le piézoactionneur (3) et la couche d'élastomère,
la douille étant formée d'un manchon flexible (26) qui rétrécit sous l'action de la température et qui repose de manière étanche dans des zones d'appui sur la tête d'actionneur (22) et/ou le pied d'actionneur (23) du piézoactionneur (21),
au moins une bague de compression (27) étant disposée par l'extérieur sur le tuyau flexible rétrécissable (26) et repoussant le tuyau flexible rétrécissable (26) sur les zones d'appui,
chaque bague de compression (27) présentant sur la surface de son contour extérieur et/ou de son contour intérieur (30) au moins un rabattement débordant vers l'extérieur qui donne une hystérésis élastique à la bague de compression (27) même en cas de modification de volume ou de position du tuyau flexible rétrécissable (26), la force de compression de chaque anneau de compression (27) étant maintenue.

3. Module d'actionneur selon l'une des revendications précédentes, **caractérisé en ce que** chaque anneau de compression (27) présente sur la surface de son contour intérieur des reliefs radiaux périphériques (31) qui ont pour effet un engagement du tuyau flexible rétrécissable (26) comprimé par l'anneau de compression (27).

4. Module d'actionneur selon l'une des revendications précédentes, **caractérisé en ce qu'**au moins un relief radial périphérique (32) ou un creux radial périphérique (33) sont disposés à la périphérie de la zone d'appui du tuyau flexible rétrécissable (26) sur la tête d'actionneur (22) et/ou sur le pied d'actionneur et présentent une section transversale rectangulaire ou conique.

5. Module d'actionneur selon l'une des revendications précédentes, **caractérisé en ce que** le piézoactionneur (21) fait partie d'un piézoinjecteur d'un système d'injection de carburant d'un moteur à combustion interne, le carburant balayant l'extérieur du manchon flexible rétrécissable (26).
